# EUROPEAN PATENT APPLICATION

(11) **EP 4 654 430 A2**
(43) Date of publication of application: **26.11.2025**
(21) Application number: 25172588.3
(22) Date of filing: 25.04.2025
(51) Int. Cl.: H02J 7/00

(54) **BATTERY OVERCHARGING PREVENTION DEVICE AND METHOD, AND BATTERY PACK**

(30) Priority: 23.05.2024 KR 20240066999
(71) Applicant: SAMSUNG SDI CO., LTD., Yongin-si, Gyeonggi-do 17084 (KR)
(72) Inventor: SEO, Young Dong, 16678 Suwon-si, Gyeonggi-do (KR); YOO, Jae Shik, 16678 Suwon-si, Gyeonggi-do (KR); KIM, Ji Hoon, 16678 Suwon-si, Gyeonggi-do (KR)
(74) Representative: Gulde & Partner

(57) **Abstract**

A battery overcharging prevention device includes a bypass circuit configured to bypass a current flowing into each of first to Nth battery modules that are connected in parallel (N being a natural number greater than or equal to 2) wherein each one of the first to Nth battery modules includes a plurality of battery cells connected in series; and a processor configured to prevent overcharging caused by charging and discharging performed between the first to Nth battery modules, wherein the processor is configured to detect a target battery module of the first to Nth battery modules in which an abnormal battery cell is present based on a voltage change in each of the battery cells in the first to Nth battery modules, and to prevent overcharging of the target battery module by bypassing the current flowing into the target battery module through the bypass circuit.

## Description

### BACKGROUND

### 1. Field

Aspects of the present disclosure relate to battery overcharge prevention.

### 2. Description of the Related Art

Secondary batteries are batteries, that can be charged and discharged, unlike primary batteries, which cannot be re-charged. Low-capacity secondary batteries are used in small portable electronic devices such as smartphones, feature phones, laptop computers, digital cameras, and camcorders, and high-capacity secondary batteries are widely used as motor driving power sources, power storage batteries, and the like in hybrid vehicles, electric vehicles, and the like. These secondary batteries include an electrode assembly composed of a positive electrode and a negative electrode, a case that accommodates the same, and an electrode terminal connected to the electrode assembly.

The above information disclosed in this Background section is for enhancement of understanding of the background of the present disclosure, and therefore, it may contain information that does not constitute related (or prior) art.

### SUMMARY

Aspects of embodiments of the present disclosure is directed to a battery overcharging prevention device and method capable of substantially reducing or preventing overcharging caused in a specific battery module according to a charging and discharging operation performed between a plurality of battery modules connected in parallel, and a battery pack to which the function is applied.

However, objects that the present invention intends to achieve are not limited to the above-described objects and other objects that are not described may be clearly understood by those skilled in the art from the following description.

According to some embodiments of the present disclosure, there is provided a battery overcharging prevention device including: a bypass circuit configured to bypass a current flowing into each of first to Nth battery modules that are connected in parallel (N being a natural number greater than or equal to 2) wherein each one of the first to Nth battery modules includes a plurality of battery cells connected in series; and a processor configured to prevent overcharging caused by charging and discharging performed between the first to Nth battery modules, wherein the processor is configured to detect a target battery module of the first to Nth battery modules in which an abnormal battery cell is present based on a voltage change in each of the battery cells in the first to Nth battery modules, and to prevent overcharging of the target battery module by bypassing the current flowing into the target battery module through the bypass circuit.

In some embodiments, the first to Nth battery modules form a battery pack; and the processor is configured to start a detecting operation of the abnormal battery cell and the target battery module, in response to the current drawn out from the battery pack being in a preset reference current range.

In some embodiments, the processor is configured to start a detecting operation of the abnormal battery cell and the target battery module in response to a current flow occurring between the first to Nth battery modules.

In some embodiments, the processor is configured to detects the target battery module by determining whether a battery cell having an increasing voltage and a battery cell having a decreasing voltage are present among a plurality of battery cells in any one battery module of the first to Nth battery modules.

In some embodiments, based on an Mth battery module of the first to Nth battery modules (M being a natural number smaller than or equal to N), the processor is configured to detect the target battery module by determining whether i) a first condition that a battery cell having a voltage increasing above a preset first reference voltage is present, and ii) a second condition that a battery cell having a voltage decreasing below a preset second reference voltage is present are satisfied.

In some embodiments, the processor is configured to detect the Mth battery module as the target battery module in response to the first and second conditions being satisfied, and a voltage change rate of each of the plurality of battery cells that satisfy the first condition being in a preset tolerance range.

In some embodiments, the processor is configured to detect the Mth battery module as the target battery module in response to identifying that a situation in which the first and second conditions are satisfied is repeated a preset number of times or more.

In some embodiments, the bypass circuit includes a plurality of sub-bypass circuits; and each of the sub-bypass circuits includes a bypass switch and a bypass resistor connected in series.

In some embodiments, the plurality of sub-bypass circuits form bypass paths connected to each of the first to Nth battery modules that are in parallel to bypass a charging current flowing into corresponding battery modules of the first to Nth battery modules; and each bypass path of the bypass paths is configured as a path connecting a current input node to an uppermost battery cell of the corresponding battery modules, the bypass switch, the bypass resistor, and a discharging terminal.

In some embodiments, the processor is configured to close the bypass switch of a sub-bypass circuit of the sub-bypass circuits connected to the target battery module to bypass the charging current flowing into the target battery module through the bypass path.

In some embodiments, the bypass circuit includes sub-bypass circuits; and each of the sub-bypass circuits includes a connection changeover switch, a bypass switch, and a bypass resistor connected in series.

In some embodiments, the connection changeover switch, the bypass switch, and the bypass resistor form a bypass path for bypassing a charging current flowing into each of a first battery module and a second battery module of the first to Nth battery modules that are adjacent to each other and connected in parallel.

In some embodiments, the connection changeover switch includes first to third nodes, and is configured to selectively connect the first and second nodes to the third node; the first node is connected to a current input node of an uppermost battery cell of the first battery module; the second node is connected to a current input node of the uppermost battery cell of the second battery module; and the third node is connected to the bypass switch.

In some embodiments, the bypass path of the first battery module is configured as a path connecting the first node, the bypass switch, the bypass resistor, and a discharging terminal; and the bypass path of the second battery module is configured as a path connecting the second node, the bypass switch, the bypass resistor, and a discharging terminal.

In some embodiments, the processor is configured to connect the third node to the first node and to close the bypass switch to bypass the charging current flowing into the first battery module through the bypass path in response to the first battery module being detected as the target battery module, and to the third node to the second node and to close the bypass switch to bypass the charging current flowing into the second battery module through the bypass path in response to the second battery module being detected as the target battery module.

In some embodiments, the bypass circuit includes first to Kth sub-bypass circuits (K being a natural number corresponding to floor (N/2), floor being a descending operator); and an Lth sub-bypass circuit of the first to Kth sub-bypass circuits forms a shared bypass path for bypassing a charging current flowing into each of a 2L-1th battery module and a 2Lth battery module of the first to Nth battery modules (L being a natural number smaller than or equal to K).

According to some embodiments of the present disclosure, there is provided a battery overcharging prevention method including: detecting, by a processor, a target battery module in which an abnormal battery cell is present based on a voltage change in each of battery cells in first to Nth battery modules (N is a natural number greater than or equal to 2) that are connected in parallel, each battery module including a plurality of battery cells connected in series; and bypassing, by the processor, a current flowing into the target battery module to prevent overcharging of the target battery module caused by a charging current flowing into the target battery module from another battery module of the first to Nth battery modules connected in parallel to the target battery module.

In some embodiments, in the detecting, the processor is configured to detect the target battery module by determining whether a battery cell having an increasing voltage and a battery cell having a decreasing voltage are present among a plurality of battery cells in any one battery module of the first to Nth battery modules.

In some embodiments, in the bypassing, the processor is configured to bypass the current flowing into the target battery module using a bypass circuit configured to bypass the current flowing into each of the first to Nth battery modules.

Further, the battery overcharging prevention method may adaptably implement all features of the above-mentioned battery overcharging prevention device.

A battery pack including: first to Nth battery modules connected in parallel (N is a natural number greater than or equal to 2), wherein each battery module of the first to Nth battery modules includes a plurality of battery cells connected in series; and a battery management system (BMS) configured to prevent overcharging caused by charging and discharging performed between the first to Nth battery modules, wherein the BMS is configured to detect a target battery module of the first to Nth battery modules in which an abnormal battery cell is present based on a voltage change in each of the battery cells in the first to Nth battery modules, and to prevent overcharging of the target battery module by bypassing a current flowing into the target battery module. The BMS may comprise the above-mentioned battery overcharging prevention device.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 illustrates a battery module according to some embodiments of the present disclosure;
FIGS. 2A and 2B illustrate a battery pack according to some embodiments of the present disclosure;
FIG. 3 illustrates a parallel connection structure of the battery module according to some embodiments of the present disclosure;
FIG. 4 illustrates a block diagram of a battery overcharging prevention device according to some embodiments of the present disclosure;
FIGS. 5 and 6 illustrate an example of a process of detecting abnormal battery cells in the battery overcharging prevention device according to some embodiments of the present disclosure;
FIGS. 7 and 8 illustrate a first example of a process of bypassing a charging current through a bypass circuit unit in the battery overcharging prevention device according to some embodiments of the present disclosure;
FIGS. 9 to 12 illustrate a second example of the process of bypassing the charging current through the bypass circuit unit in the battery overcharging prevention device according to some embodiments of the present disclosure; and
FIG. 13 illustrates a flowchart of a battery overcharging prevention method according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to their usual or dictionary meanings and should be interpreted as meanings and concepts consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B, and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Herein, "Abnormal battery cell" represented in the embodiment is defined as a battery cell in which a short circuit occurs in the cell or a short circuit between the cell and an external low-voltage terminal (e.g., GND) occurs and thus a voltage decrease is exhibited due to self-discharging. Further, "target battery module" is defined as a battery module including an abnormal battery cell. Some embodiments focus on an overcharging prevention mechanism that bypasses a charging current to a target battery module M_{target} in which an abnormal battery cell Cₛₕₒᵣₜ is present to prevent overcharging of the corresponding battery module, and provide structures of the battery module and a battery pack. These provide the mechanism that prevents the overcharging of the target battery module caused by the abnormal battery cell Cₛₕₒᵣₜ. The battery cells included in the battery module may be implemented in various suitable structures and shapes, such as cylindrical secondary battery cells, prismatic secondary battery cells, coin-shaped secondary battery cells, and/or the like.

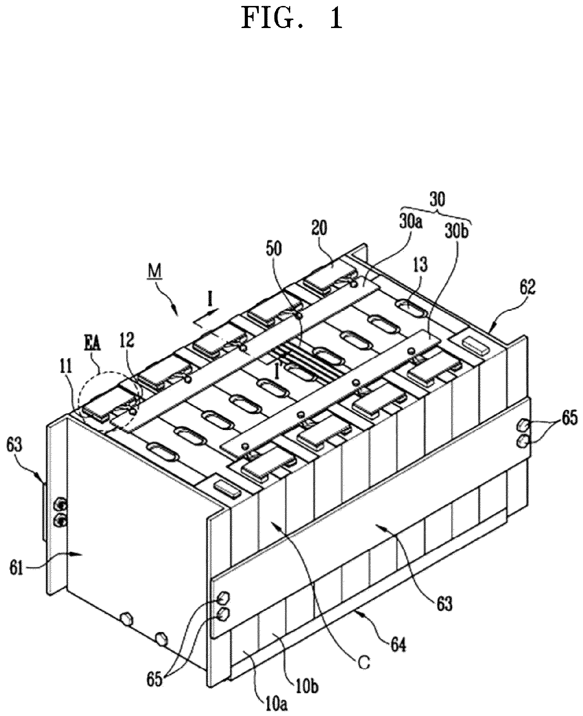

FIG. 1 is a perspective view illustrating the battery module M according to some embodiments of the present disclosure.

Referring to FIG. 1, the battery module M, according to some embodiments of the present disclosure, includes a plurality of battery cells C which include terminal portions 11 and 12 and are arranged in one direction, a connection tab 20 which connects a battery cell 10a and an adjacent battery cell 10b, and a protection circuit module 30 of which one end portion is connected to the connection tab 20. The protection circuit module 30 may be a battery management system (BMS). In addition, the connection tab 20 includes a body portion in contact with the terminal portions 11 and 12 between adjacent battery cells 10a and 10b, and an extension portion that extends from the body portion 22 and is connected to the protection circuit module 30. The connection tab 20 may be a busbar.

The battery cell C may include a battery case, and an electrode assembly and an electrolyte accommodated in the battery case. The electrode assembly and the electrolyte electrochemically react with each other to generate energy. The terminal portions 11 and 12 electrically connected to the connection tab 20 and a vent 13, which is a discharge passage for gas generated inside of the battery cell C, may be provided at one side of the battery cell C. The terminal portions 11 and 12 of the battery cell 10 may be a positive electrode terminal 11 and a negative electrode terminal 12 having different polarities. The terminal portions 11 and 12 of adjacent battery cells 10a and 10b may be electrically connected in series or parallel by the connection tab 20. Although an example of serial connection has been described above, the present disclosure is not limited to such a structure, and various suitable connection structures can be adopted as desired. In addition, the number and arrangement of the battery cells C are not limited to the structure shown in FIG. 1 and may be changed as desired.

The plurality of battery cells C may be arranged in one direction such that wide surfaces of the battery cells C face each other, and the plurality of arranged battery cells C may be fixed by housings 61, 62, 63, and 64. The housings 61, 62, 63, and 64 may include a pair of end plates 61 and 62 facing the wide surfaces of the battery cells 10, and side plates 63 and a bottom plate 64 which connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected by members such as bolts 65 or the like.

The protection circuit module 30 may be mounted with electronic components and protection circuits and may be electrically connected to the connection tab 20. The protection circuit module 30 may include a first protection circuit module 30a and a second protection circuit module 30b that extend at different positions in a direction in which the plurality of battery cells C are arranged. In such examples, the first protection circuit module 30a and the second protection circuit module 30b may be spaced a certain interval apart from each other, may be positioned parallel to each other, and may each be electrically connected to the connection tab 20 adjacent thereto. For example, the first protection circuit module 30a may be formed to extend at one upper side of the plurality of battery cells C in the direction in which the plurality of battery cells C are arranged, and the second protection circuit module 30b may be formed to extend at the other upper side of the plurality of battery cells C in the direction in which the plurality of battery cells C are arranged. The second protection circuit module 30b may be positioned to be spaced a certain interval apart from the first protection circuit module 30a with the vent 13 interposed therebetween and may be disposed parallel to the first protection circuit module 30a. In this way, two protection circuit modules are disposed in parallel and spaced apart from each other in the direction in which the plurality of battery cells C are arranged, thereby reducing (e.g., minimizing) an area of a printed circuit board (PCB) constituting the protection circuit module. That is, the protection circuit module is provided as two separate protection circuit modules, thereby reducing (e.g., minimizing) an unnecessary PCB area. The first protection circuit module 30a and the second protection circuit module 30b may be connected to each other by a conductive connection member 50. In such examples, one side of the connection member 50 may be connected to the first protection circuit module 30a, and the other side thereof may be connected to the second protection circuit module 30b so that an electrical connection may be made between the two protection circuit modules.

The connection may be performed through any method of soldering, resistance welding, laser welding, projection welding methods, and/or the like.

The connection member 50 may be, for example, an electric wire. In addition, the connection member 50 may be made of an elastic or flexible material. Through the connection member 50, it is possible to check and manage whether the voltage, temperature, and current of the plurality of battery cells C are normal. That is, information about a voltage, a current, a temperature, or the like received by the first protection circuit module from the connection tabs adjacent thereto and information about a voltage, a current, a temperature, or the like received by the second protection circuit module from the connection tabs adjacent thereto may be integrally managed through the connection member 50 by the protection circuit module 30.

In addition, when the battery cell C swells, an impact is absorbed due to the elasticity or flexibility of the connection member 50, thereby substantially reducing or preventing damage to the first and second protection circuit modules 30a and 30b.

In addition, the shape and structure of the connection member 50 are not limited to the shape shown in FIG. 1.

In this way, the protection circuit module 30 is provided as the first and second protection circuit modules 30a and 30b, the area of the PCB constituting the protection circuit module can be reducing (e.g., minimized), thereby securing a space inside the battery module M. Thus, a fastening operation of connecting the connection tab 20 and the protection circuit module 30 may be facilitated, and also a repair may be facilitated when an abnormality is detected in the battery module M, thereby improving operation efficiency.

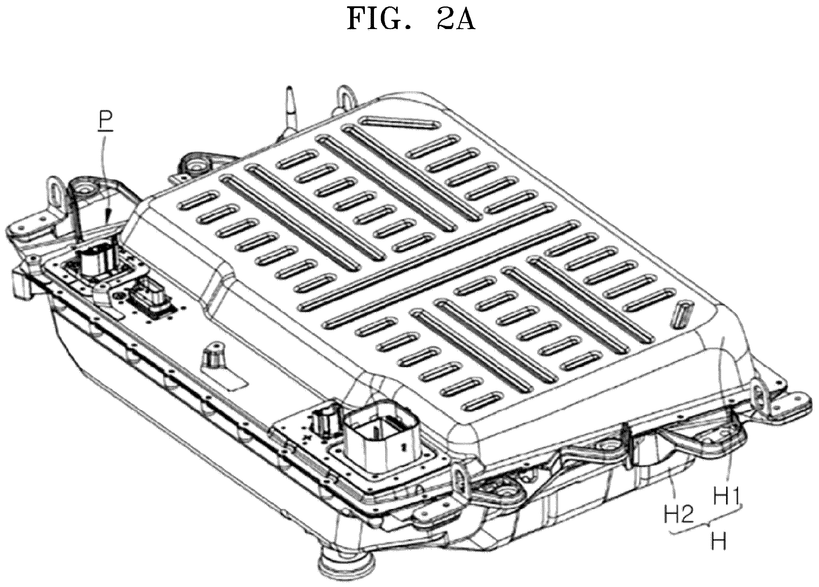

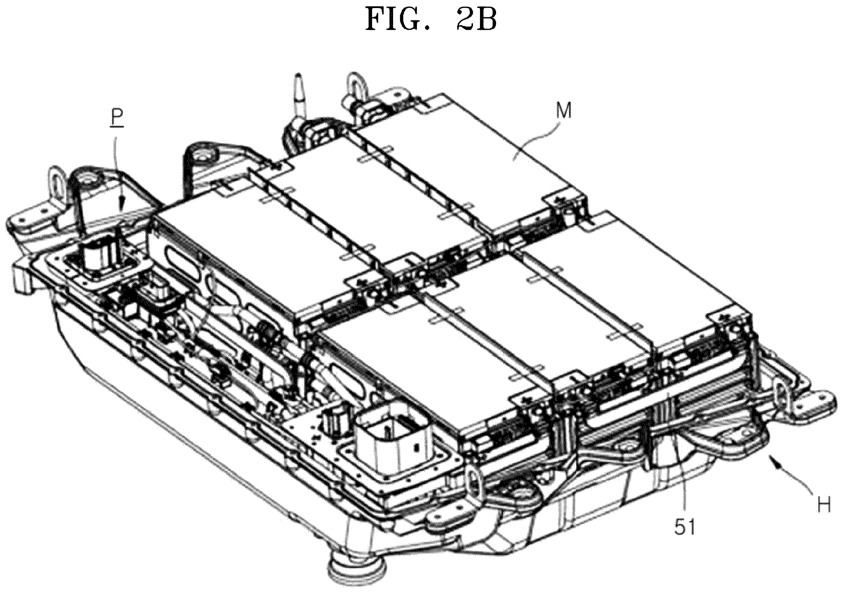

FIGS. 2A and 2B illustrate the battery pack P according to some embodiments of the present disclosure.

The battery pack P may include a plurality of battery modules M and a housing H for accommodating the plurality of battery modules M. For example, the housing H may include first and second housings H1 and H2 that are coupled to face each other with the plurality of battery modules M interposed therebetween. The plurality of battery modules M may be electrically connected to each other using a busbar 51, and the plurality of battery modules M may be electrically connected to each other in series, in parallel, or in a series-parallel combination scheme to obtain the desired electrical output power.

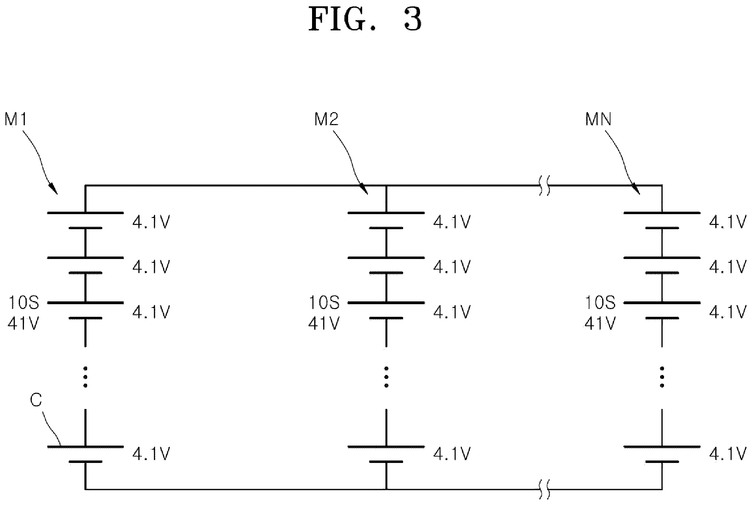

In the above, a general battery structure in which battery cells C are interconnected in series or parallel to constitute battery modules M, and the battery modules M are interconnected in series or parallel to constitute a battery pack P has been described. Among these battery connection structures, as will be described further below, some embodiments provide a structure in which a plurality of battery cells C are connected in series to constitute the battery modules M, and a plurality of battery modules M are connected in parallel to constitute the battery pack P. The battery pack P includes first to Nth battery modules M1 to MN that are connected in parallel, and each of the battery modules M1 to MN may include a plurality of battery cells C connected in series. FIG. 3 illustrates a structure in which N battery modules M, each composed of ten battery cells C connected in series, are connected in parallel, that is, an example in which a battery cell voltage in a normal state is 4.1 V and a battery module voltage is 41 V. Using this battery structure example, an overcharging prevention mechanism of the embodiment will be described below in further detail.

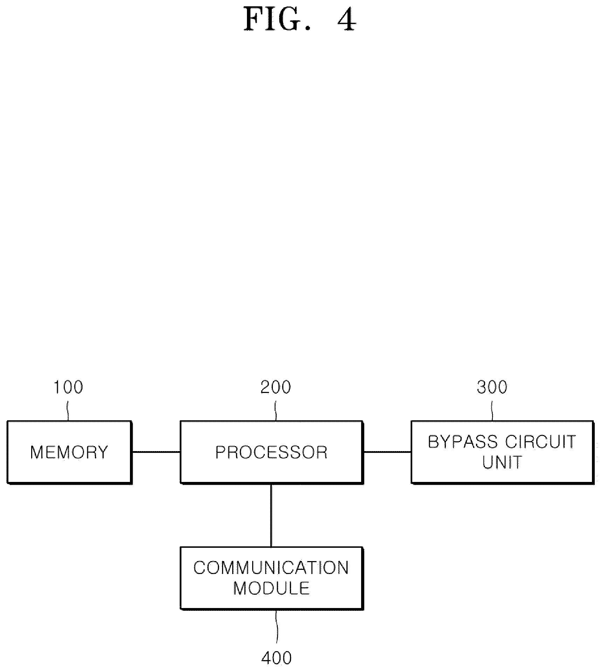

FIG. 4 is a block diagram for describing a battery overcharging prevention device according to some embodiments of the present disclosure. Referring to FIG. 4, the battery overcharging prevention device of the embodiment may include a memory 100, a processor 200, a bypass circuit unit 300, and a communication module 400. The battery overcharging prevention device in FIG. 4 may constitute the battery pack P along with a plurality of battery modules M1 to MN.

At least one command executed by the processor 200 may be stored in the memory 100. The memory 100 may be implemented as a volatile storage medium and/or a non-volatile storage medium, and may be implemented as, for example, a read only memory (ROM) and/or a random access memory (RAM).

Further, values of a reference current range, a first reference voltage, a second reference voltage, a tolerance range, and a reference number of times may be stored in the memory 100 in advance, and each value stored in the memory 100 may be utilized in a process of detecting the abnormal battery cells Cₛₕₒᵣₜ and the target battery module M_{target} in which the abnormal battery cells Cₛₕₒᵣₜ are present by the processor 200. The value of each of the reference current range, the first reference voltage, the second reference voltage, the tolerance range, and the reference number of times stored in the memory 100 may be predefined based on capacity of each of the battery module M and the battery pack P, an open circuit voltage (OCV), the number of battery modules M connected in parallel (e.g., N), and a resistance value of the abnormal battery cells Cₛₕₒᵣₜ to be detected.

The processor 200 is the entity that prevents or substantially reduces the overcharging of the target battery module M_{target} caused by charging and discharging performed between the first to Nth battery modules M1 to MN, and may be implemented as a central processing unit (CPU) or a system on chip (SoC), control a plurality of hardware or software components connected to the processor 200 by driving an operating system or application, and perform various types of data processing and calculations. The processor 200 may be configured to execute at least one command stored in the memory 100 and store the execution result data in the memory 100.

The processor 200 may be implemented as a battery management system (BMS) provided in the battery pack P or a micro controller unit (MCU) in the BMS, and may be configured to detect a current, a voltage, and a temperature at a level of the battery cells C, a current, a voltage, and a temperature at a level of the battery modules M, and a current, a voltage, and a temperature at a level of the battery pack P. A sensing function of the BMS may support a sensing operation of a current drawn out from the battery pack P, a sensing operation of a current flow between the battery modules M, and a sensing operation of the voltage of the battery cells C utilized in a process of detecting the abnormal battery cells Cₛₕₒᵣₜ and the target battery module M_{target}.

The communication module 400 may establish a wired or wireless communication link between the processor 200 and a user terminal (e.g., a telematics terminal possessed by a user or a dedicated terminal provided for implementing the embodiment), and may be implemented as a communication circuit which establishes, for example, a controller area network (CAN) communication link, a local interconnect network (LIN) communication link, or an Ethernet communication link between the processor 200 and the user terminal. The communication link established by the communication module 400 may function as a channel through which detection information of the abnormal battery cells Cₛₕₒᵣₜ is transmitted from the processor 200 to the user terminal.

The bypass circuit unit 300 may be configured to bypass the charging current flowing into each of the first to Nth battery modules M1 to MN interconnected in parallel, and may function as an energy drain system (EDS) which discharges energy applied to the target battery module M_{target} by bypassing the charging current flowing into the target battery module M_{target} in which the abnormal battery cells Cₛₕₒᵣₜ are present. The bypass circuit unit 300 may include a plurality of sub-bypass circuits 310 (e.g., 310_1, 310_2, and 310_3), and each of the sub-bypass circuits 310 (e.g., 310_1, 310_2, and 310_3) may include a bypass switch 311 (e.g., a relay or field effect transistor (FET)) and a bypass resistor 312. A path connecting a node through which charging current flows into the uppermost battery cell of the target battery module M_{target}, the bypass switch 311, the bypass resistor 312, and a discharge terminal P_{DCG} constitutes a bypass path P_{bypass} for bypassing the charging current flowing into the target battery module M_{target}. A bypass operation of the charging current through the bypass circuit unit 300 will be described further below.

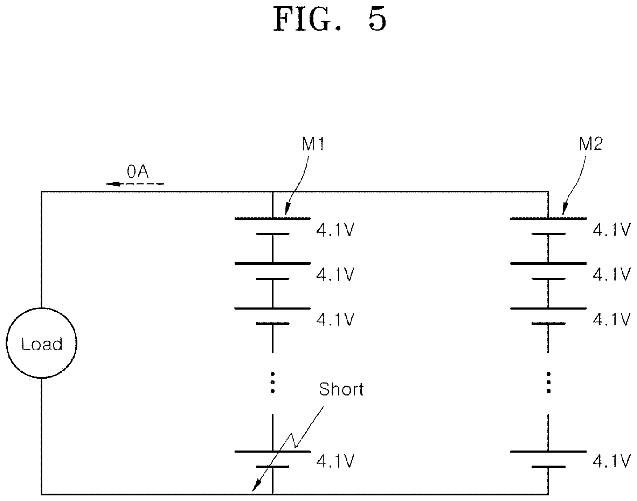

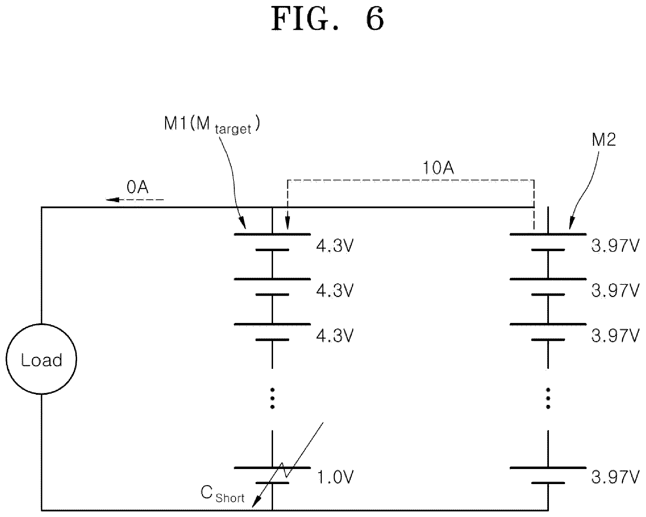

FIGS. 5 and 6 illustrate an example of a process of detecting the abnormal battery cells in the battery overcharging prevention device according to some embodiments of the present disclosure.

As shown in FIG. 5, when an internal short circuit or an external short circuit occurs in one or more of the plurality of battery cells C included in the first battery module M1, as shown in FIG. 6, even when charging and discharging of the battery pack P are not performed, charging and discharging occur between the first and second battery modules M1 and M2 connected in parallel. The numerical values provided in FIGS. 5 and 6 are merely examples intended to aid in understanding some embodiments of the present disclosure, and the present disclosure is not limited thereto.

For example, in the case of the abnormal battery cells Cₛₕₒᵣₜ in which the short circuit occurs, a cell voltage decreases due to self-discharging, and accordingly, because a voltage difference is formed between a module voltage of the first battery module M1 including the abnormal battery cells Cₛₕₒᵣₜ and a module voltage of the second battery module M2, the current flows from the second battery module M2 to the first battery module M1. Accordingly, a voltage of the abnormal battery cells Cₛₕₒᵣₜ of the first battery module M1 continuously decreases, but because the normal battery cells of the first battery module M1 are continuously charged and the voltage continuously increases due to the charging current flowing into the first battery module M1 from the second battery module M2, as a result, the overcharging occurs.

In order to prevent the overcharging of the normal battery cells due to occurrence of the abnormal battery cells Cₛₕₒᵣₜ as described above, the processor 200 may operate to detect the abnormal battery cells Cₛₕₒᵣₜ and the target battery module M_{target} in which abnormal battery cells Cₛₕₒᵣₜ are present, which will be described below in further detail.

As mentioned above, in the case of the target battery module M_{target} in which the abnormal battery cells Cₛₕₒᵣₜ has occurred, because voltage change patterns of the abnormal battery cells Cₛₕₒᵣₜ and the normal battery cells are different, the processor 200 may detect the abnormal battery cells Cₛₕₒᵣₜ and the target battery module M_{target} in which the abnormal battery cells Cₛₕₒᵣₜ are present based on a voltage change in each of the battery cells C included in the first to Nth battery modules M1 to MN.

In such examples, the processor 200 may initiate a detecting operation of the abnormal battery cells Cₛₕₒᵣₜ and the target battery module M_{target} in a state in which a load Load is not driven by power supplied from the battery pack P. In examples in which the load Load is a motor, when the motor is driven by the battery pack P, because discharging and regenerative charging frequently occur and thus voltage fluctuations occur in the battery pack P, the battery module M, and the battery cells C, different voltage change patterns of the abnormal battery cells Cₛₕₒᵣₜ and the normal battery cells caused by the occurrence of the abnormal battery cells Cₛₕₒᵣₜ may not be accurately identified.

That is, in the detection operation of the abnormal battery cells Cₛₕₒᵣₜ and the target battery module M_{target}, a state in which the charging and discharging are performed between the battery modules M are to be considered, and this means that a state in which the charging and discharging are not performed at a level of the battery pack P are to be considered. Accordingly, the processor 200 may initiate the detection operation of the abnormal battery cells Cₛₕₒᵣₜ and the target battery module M_{target} only in a load-non-driven state. The processor 200 may determine the load-non-driven state based on the magnitude of the current drawn out from the battery pack P, and for example, when the magnitude of the current drawn out from the battery pack is in a reference current range stored in the memory 100 (e.g., from -1 A to 1 A), the processor 200 may determine the load-non-driven state and initiate the detection operation of the abnormal battery cells Cₛₕₒᵣₜ and the target battery module M_{target}.

In order to eliminate the inefficiency of performing the detection operation of the abnormal battery cells Cₛₕₒᵣₜ and the target battery module M_{target} in a state in which the charging and discharging are not performed between the first to Nth battery modules M1 to MN, the processor 200 may be configured to initiate the detection operation of the abnormal battery cells Cₛₕₒᵣₜ and the target battery module M_{target} only when the current flow occurs between the first to Nth battery modules M1 to MN (i.e., only when the charging and discharging are performed between the first to Nth battery modules M1 to MN).

When the detection operation of the abnormal battery cells Cₛₕₒᵣₜ and the target battery module M_{target} is initiated, the processor 200 may detect the target battery module M_{target} by (e.g., in a manner of) determining whether a battery cell C having an increasing voltage and a battery cell C having a decreasing voltage are present among the plurality of battery cells C included in any one battery module M.

For example, based on the Mth battery module (M being a natural number smaller than or equal to N), the processor 200 may detect the target battery module M_{target} by (e.g., in a manner of) determining whether i) a first condition that a battery cell C having a voltage increasing above a preset first reference voltage is present, and ii) a second condition that a battery cell C having a voltage decreasing below a preset second reference voltage is present are satisfied (the first reference voltage has a value greater than the second reference voltage. Battery cells C satisfying the first condition corresponds to the normal battery cells, battery cells C satisfying the second condition correspond to the abnormal battery cells Cₛₕₒᵣₜ, and the battery module M including both the normal battery cells and the abnormal battery cells Cₛₕₒᵣₜ may be detected as the target battery module M_{target}.

In order to increase detection accuracy of the abnormal battery cells Cₛₕₒᵣₜ and the target battery module M_{target}, the processor 200 may be configured to detect the corresponding battery module (e.g., the Mth battery module in the above example) as the target battery module M_{target} when the first and second conditions are satisfied, and thus a voltage change rate (i.e., the voltage change amount per unit time) of each of the plurality of battery cells C, which satisfy the first condition is in a preset tolerance range. That is, even when the plurality of battery cells C included in the Mth battery module satisfy the first condition and thus are detected as the normal battery cells, when a pattern of a voltage increase to the first reference voltage is different for the battery cells that satisfy the first condition, a cause of the voltage increase may not be specified as charging and discharging between the battery modules M due to the abnormal battery cells Cₛₕₒᵣₜ. On the other hand, when the charging and discharging are performed between the battery modules (M) due to the abnormal battery cells Cₛₕₒᵣₜ, because the voltage increase patterns of the normal battery cells to the first reference voltage will be similar, the processor 200 may determine similarity of the voltage increase patterns of the plurality of battery cells C, which satisfy the first condition, to improve the detection accuracy of the abnormal battery cells Cₛₕₒᵣₜ and the target battery module M_{target}. The voltage change rate (i.e., the voltage change amount per unit time; e.g., a voltage increase rate per unit time) may be adopted as a quantitative standard for determining the similarity of the voltage increase patterns, and accordingly, the corresponding battery module M may be detected as the target battery module M_{target} only when the voltage change per unit time of each of the plurality of battery cells C, which satisfy the first condition, is in a preset tolerance range.

As an additional means for improving the detection accuracy of the abnormal battery cells Cₛₕₒᵣₜ and the target battery module M_{target}, a configuration in which the corresponding battery module M is detected as the target battery module M_{target} may be provided when (e.g., only when) a situation in which the first and second conditions are satisfied is repeated a preset reference number of times or more.

When the abnormal battery cells Cₛₕₒᵣₜ and the target battery module M_{target} are detected through the above process, the processor 200 may allow the user to stop using the battery pack P and perform maintenance thereof by notifying the user terminal through the communication module 400 that the abnormal battery cells Cₛₕₒᵣₜ have occurred.

When the abnormal battery cells Cₛₕₒᵣₜ and the target battery module M_{target} are detected, the processor 200 may bypass the charging current flowing into the target battery module M_{target} through the bypass circuit unit 300 to prevent the overcharging of the normal battery cells due to the charging current flowing into the target battery module M_{target} from another battery module M. Two embodiments of the overcharging prevention mechanism may be presented, and each embodiment will be described below in further detail.

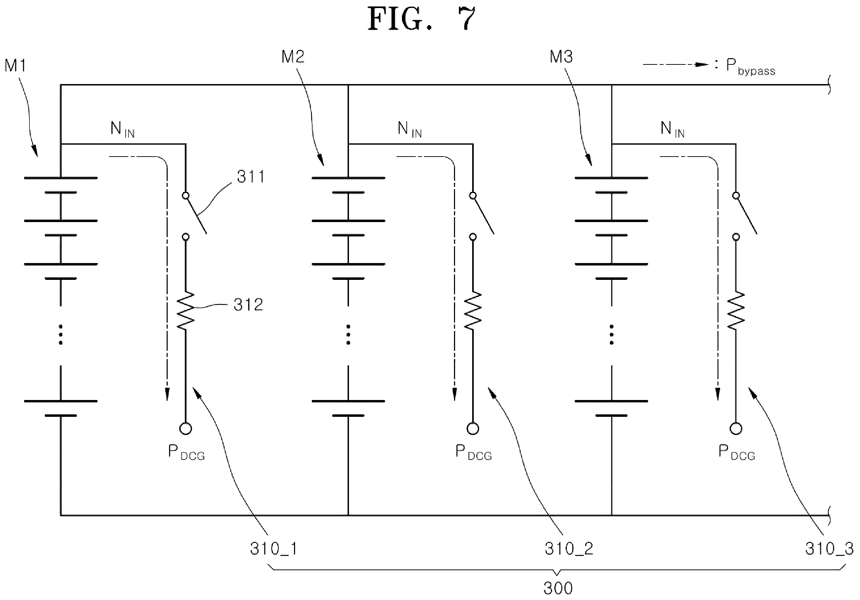

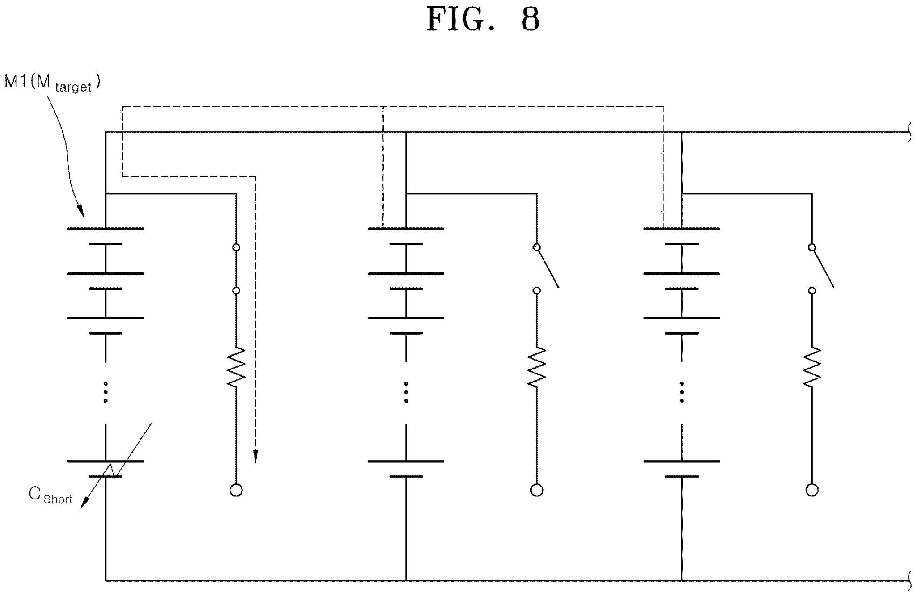

FIGS. 7 and 8 are exemplary diagrams for describing some embodiments of the overcharging prevention mechanism. Referring to FIGS. 7 and 8, the bypass circuit unit 300 of the first embodiment may include a plurality of sub-bypass circuits 310 (e.g., 310_1, 310_2, and 310_3), and each of the sub-bypass circuits 310 (e.g., 310_1, 310_2, and 310_3) may include a bypass switch 311 and a bypass resistor 312 connected in series. The bypass circuit unit 300 of the first embodiment may be provided in the battery pack P and may also be provided in a host device (e.g., a vehicle) in which the battery pack P is installed.

Referring to FIG. 7, the plurality of sub-bypass circuits 310 (e.g., 310_1, 310_2, and 310_3) may be connected in parallel to each of the first to Nth battery modules M1 to MN to form a bypass path P_{bypass} for bypassing the charging current flowing into the corresponding battery module M.

When the Mth battery module is described as an example (M being a natural number smaller than or equal to N), the bypass path P_{bypass} of the Mth battery module may be configured as a path connecting a current input node N_{IN} to the uppermost battery cell of the Mth battery module, the bypass switch 311, the bypass resistor 312, and a discharging terminal P_{DCG}. For example, the discharging terminal P_{DCG} may be implemented as a terminal capable of draining the bypassed charging current such as a ground terminal. The sub-bypass circuits 310 (e.g., 310_1, 310_2, and 310_3) may be provided for each of the first to Nth battery modules M1 to MN, and accordingly, each of the battery modules M1 to MN may be provided with the bypass path P_{bypass}, which bypasses the charging current flowing due to the occurrence of the abnormal battery cells Cₛₕₒᵣₜ.

Based on the above connection structure of the bypass circuit unit 300, the processor 200 may close the bypass switch 311 of the sub-bypass circuit connected to the target battery module M_{target} when the abnormal battery cells Cₛₕₒᵣₜ and the target battery module M_{target} (e.g., the first battery module M1 in the example in FIG. 8) are detected, and accordingly, as shown in FIG. 8, the charging current flowing into the target battery module M_{target} may be bypassed through the bypass path P_{bypass}. Here, the battery module M which is the target battery module M_{target} in which the abnormal battery cells Cₛₕₒᵣₜ has occurred may be identified by basic functions supported by the BMS.

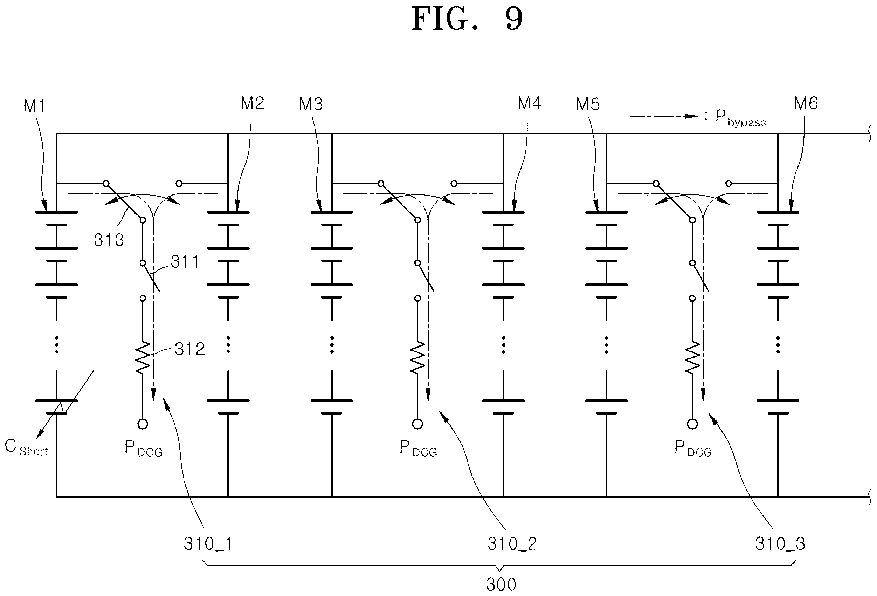

FIGS. 9 to 12 are exemplary diagrams for describing some other embodiments of the overcharging prevention mechanism. Referring to FIGS. 9 to 12, the bypass circuit unit 300 of the second embodiment may include a plurality of sub-bypass circuits 310 (e.g., 310_1, 310_2, and 310_3), and each of the sub-bypass circuits 310 (e.g., 310_1, 310_2, and 310_3) may include a connection changeover switch 313, a bypass switch 311, and a bypass resistor 312 connected in series. The bypass circuit unit 300 of the second embodiment may be provided in the battery pack P. Further, the bypass switch 311 of the second embodiment may have a normally opened (i.e., normal open) structure.

The bypass circuit unit 300 may include first to Kth sub-bypass circuits. When K is quantitatively expressed with respect to N, which represents the number of battery modules M, K may be expressed as a natural number corresponding to floor (N/2) (where floor is a descending operator). For example, when five battery modules M are connected in parallel (i.e., N is equal to 5), K may correspond to 2, and when six battery modules M are connected in parallel (i.e., N is equal to 6), K may correspond to 3.

Further, when L is defined as a natural number smaller than or equal to K, an Lth sub-bypass circuit may form (e.g., constitute) a shared bypass path P_{bypass} for bypassing a charging current flowing into each of a 2L-1th battery module and a 2Lth battery module.

FIG. 9 illustrates an example in which N is 6 and K is 3, and six battery modules M and three sub-bypass circuits 310_1, 310_2, and 310_3 are provided. A first sub-bypass circuit 310_1 may be connected between the first battery module M1 and the second battery module M2 to form (e.g., constitute) a shared bypass path for bypassing the charging currents flowing into each of the first battery module M1 and the second battery module M2. A second sub-bypass circuit 310_2 may be connected between a third battery module M3 and a fourth battery module M4 to form (e.g., constitute) a shared bypass path for bypassing charging currents flowing into each of the third battery module M3 and the fourth battery module M4. A third sub-bypass circuit 310_3 may be connected between a fifth battery module M5 and a sixth battery module M6 to form (e.g., constitute) a shared bypass path for bypassing charging currents flowing into each of the fifth battery module M5 and the sixth battery module M6.

That is, unlike the embodiments in which the sub-bypass circuit is provided for each of the battery modules M1 to MN, in some embodiments, two battery modules M share one sub-bypass circuit, and the bypass path P_{bypass} may be configured to be formed for the battery module M in which the abnormal battery cells Cₛₕₒᵣₜ has occurred among the two battery modules M by the connection changeover switch 313 of the sub-bypass circuit.

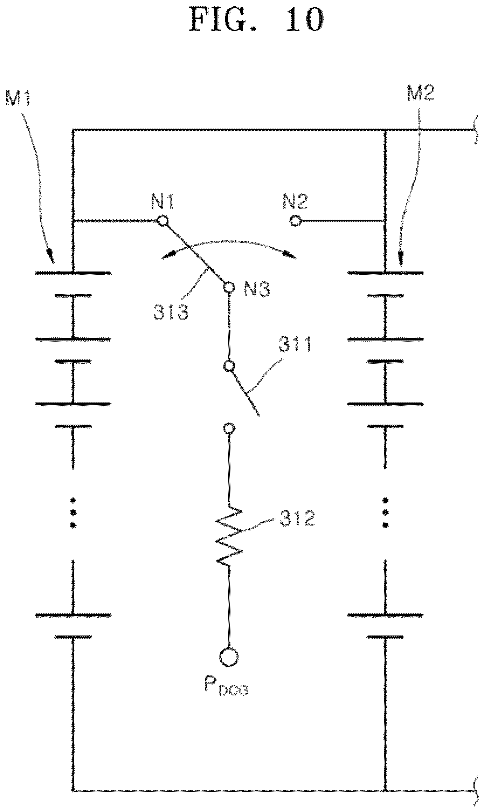

A connection structure and an operation of the sub-bypass circuit are described with reference to FIG. 10 illustrating the first and second battery modules M1 and M2 and the first sub-bypass circuit 310_1 (it should be noted that the first and second battery modules M1 and M2 represented herein are any two battery modules M that are adjacent to each other and connected in parallel among the first to Nth battery modules M1 to MN, and are not two battery modules M at extreme ends of a parallel connection structure).

The connection changeover switch 313 may have first to third nodes N1 to N3. Here, the first node N1 may be connected to a current input node of the uppermost battery cell of the first battery module M1, the second node N2 may be connected to a current input node of the uppermost battery cell of the second battery module M2, and the third node N3 may be connected to the bypass switch 311. The connection changeover switch 313 is configured to selectively connect the first and second nodes N1 and N2 to the third node N3 under control of the processor 200. The connection changeover switch 313 may be implemented as a relay including a relay coil and a switch element which performs a contact switching operation according to excitation of the relay coil. The connection changeover switch 313 may be configured to have a normally closed (i.e., normal close) structure (NC) between the first and third nodes N1 and N3 and a normally opened (i.e., normal open) structure (NO) between the second and third nodes N2 and N3, or to have a normally closed structure between the second and third nodes N2 and N3 and a normally opened structure between the first and third nodes N1 and N3. To aid in understanding the embodiments, the connection changeover switch 313 will be described below as a configuration having the normally closed structure between the first and third nodes N1 and N3 and the normally opened structure between the second and third nodes N2 and N3.

In the connection structure in FIG. 10, the bypass path P_{bypass} of the first battery module M1 may be configured as a path connecting the first node N1 (i.e., a current input node to the uppermost battery cell of the first battery module M1), the bypass switch 311, the bypass resistor 312, and the discharging terminal P_{DCG}. Further, the bypass path P_{bypass} of the second battery module M2 may be configured as a path connecting the second node N2 (i.e., a current input node to the uppermost battery cell of the second battery module M2), the bypass switch 311, the bypass resistor 312, and the discharging terminal P_{DCG}. Accordingly, the connection changeover switch 313, the bypass switch 311, and the bypass resistor 312 may form (e.g., constitute) the shared bypass path for bypassing the charging currents flowing into each of the first and second battery modules M1 and M2, which are adjacent to each other and connected in parallel.

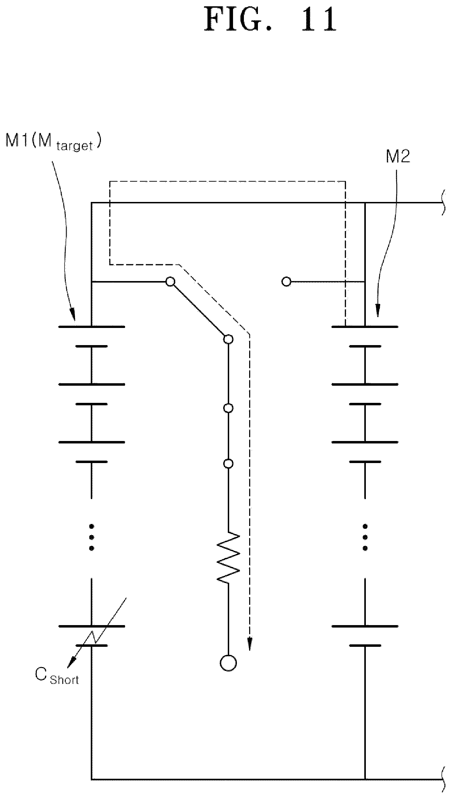

Based on the above connection structure of the bypass circuit unit 300, the processor 200 may connect the third node N3 to the first node N1 and close the bypass switch 311 to bypass the charging current flowing into the first battery module M1 through the bypass path P_{bypass} when the first battery module M1 is detected as the target battery module M_{target}. When the connection changeover switch 313 has the normally closed structure between the first and third nodes N1 and N3 and the normally opened structure between the second and third nodes N2 and N3, the bypass path P_{bypass} of the first battery module M1 may be formed only through a closing operation of the bypass switch 311. Accordingly, as shown in FIG. 11, the charging current flowing into the first battery module M1 may be bypassed through the bypass path P_{bypass}.

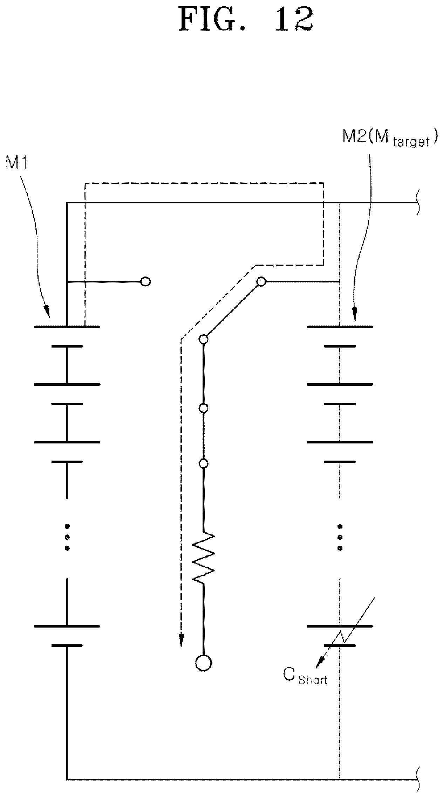

The processor 200 may connect the third node N3 to the second node N2 and close the bypass switch 311 to bypass the charging current flowing into the second battery module M2 through the bypass path P_{bypass} when the second battery module M2 is detected as the target battery module M_{target}. Accordingly, as shown in FIG. 12, the charging current flowing into the second battery module M2 may be bypassed through the bypass path P_{bypass}.

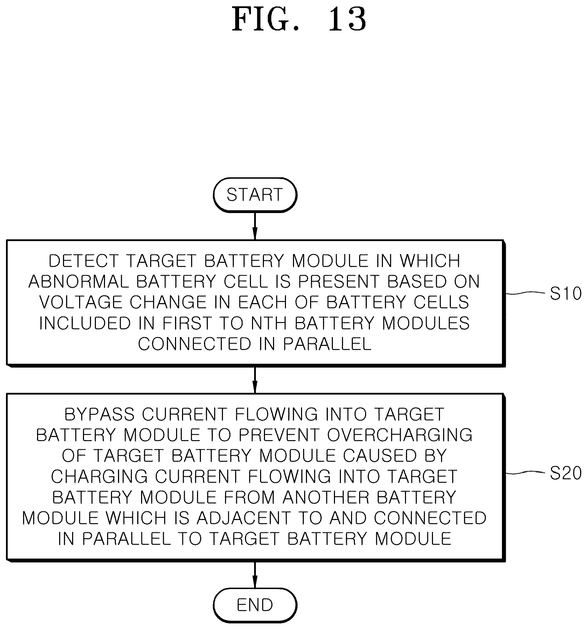

FIG. 13 is a flowchart of a battery overcharging prevention method according to some embodiments of the present disclosure. Referring to FIG. 13, the battery overcharging prevention method according to some embodiments will be described, specific description of configurations and components overlapping the above-described content will be omitted, and description will focus on a time series of configurations.

First, a processor 200 may detect abnormal battery cells Cₛₕₒᵣₜ and a target battery module M_{target} in which the abnormal battery cells Cₛₕₒᵣₜ are present based on a voltage change in each of battery cells C included in first to Nth battery modules M1 to MN that are connected in parallel (S10). This may be performed when a current drawn out from a battery pack P is in a preset reference current range and/or when a current flow occurs between the first to Nth battery modules M1 to MN.

The processor 200 may detect the target battery module M_{target} by (e.g., in a manner of) determining whether a battery cell C having an increasing voltage and a battery cell C having a decreasing voltage are present among a plurality of battery cells C included in any one battery module M. For example, based on the Mth battery module (where M is a natural number smaller than or equal to N), the processor 200 may detect the target battery module M_{target} by (e.g., in a manner of) determining whether i) a first condition that a battery cell C having a voltage increasing above a preset first reference voltage is present, and ii) a second condition that a battery cell C having a voltage decreasing below a preset second reference voltage is present are satisfied.

In such examples, the processor 200 may detect the above-described Mth battery module as the target battery module M_{target} when the first and second conditions are satisfied, and thus a voltage change rate (i.e., the voltage change amount per unit time) of each of the plurality of battery cells C, which satisfy the first condition is in a preset tolerance range. In addition, the processor 200 may detect the Mth battery module as the target battery module M_{target} when a situation in which the first and second conditions are satisfied is repeated a preset number of times or more.

Subsequently, the processor 200 bypasses a current flowing into the target battery module M_{target} using a bypass circuit unit 300 to prevent or substantially reduce overcharging of the target battery module M_{target} caused by a charging current flowing into the target battery module M_{target} from another battery module M connected in parallel to the target battery module M_{target} as detected by the processor 200 (S20).

In some embodiments, the processor 200 may close a bypass switch 311 of a sub-bypass circuit connected to the target battery module M_{target} to bypass the charging current flowing into the target battery module M_{target} through a bypass path P_{bypass}.

In some other embodiments, the processor 200 i) may connect a third node N3 to a first node N1 and close the bypass switch 311 to bypass the charging current flowing into the first battery module M1 through the bypass path P_{bypass} when the first battery module M1 is detected as the target battery module M_{target}, and ii) may connect the third node N3 to a second node N2 and close the bypass switch 311 to bypass the charging current flowing into the second battery module M2 through the bypass path P_{bypass} when the second battery module M2 is detected as the target battery module M_{target}.

Thus, according to some embodiments of the present disclosure, as a configuration of detecting abnormal battery cells in which a short circuit has occurred and a target battery module including the abnormal battery cells based on voltage behavior of the battery cells, and bypassing a charging current flowing into the target battery module through a bypass circuit composed of a switching element and a resistor element is adopted, an overcharging phenomenon of the target battery module can be prevented or substantially reduced and risks of battery ignition and explosion due to overcharging can be eliminated.

However, effects that can be achieved through the present invention are not limited to the above-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (e.g., discussed only as a method), features discussed herein may also be implemented in other forms (e.g., a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

## Claims

1. A battery overcharging prevention device comprising:
a bypass circuit configured to bypass a current flowing into each of first to Nth battery modules that are connected in parallel, N being a natural number greater than or equal to 2, wherein each one of the first to Nth battery modules comprises a plurality of battery cells connected in series; and
a processor (200) configured to prevent overcharging caused by charging and discharging performed between the first to Nth battery modules,
wherein the processor (200) is configured to detect a target battery module of the first to Nth battery modules in which an abnormal battery cell is present based on a voltage change in each of the battery cells in the first to Nth battery modules, and to prevent overcharging of the target battery module by bypassing the current flowing into the target battery module through the bypass circuit.

2. The battery overcharging prevention device of claim 1, wherein:
the processor (200) is configured to start a detecting operation of the abnormal battery cell and the target battery module, in response to:
the current drawn out from a battery pack including the first to Nth battery modules being in a preset reference current range, or
a current flow occurring between the first to Nth battery modules.

3. The battery overcharging prevention device of claim 1 or 2, wherein the processor (200) is configured to detect the target battery module by determining whether a battery cell having an increasing voltage and a battery cell having a decreasing voltage are present among a plurality of battery cells in any one battery module of the first to Nth battery modules.

4. The battery overcharging prevention device of claim 3, wherein, based on an Mth battery module of the first to Nth battery modules,M being a natural number smaller than or equal to N, the processor (200) is configured to detect the target battery module by determining whether i) a first condition that a battery cell having a voltage increasing above a preset first reference voltage is present, and ii) a second condition that a battery cell having a voltage decreasing below a preset second reference voltage is present are satisfied.

5. The battery overcharging prevention device of claim 4, wherein the processor (200) is configured to detect the Mth battery module as the target battery module in response to the first and second conditions being satisfied, and a voltage change rate of each of the plurality of battery cells that satisfy the first condition being in a preset tolerance range.

6. The battery overcharging prevention device of claim 4, wherein the processor (200) is configured to detect the Mth battery module as the target battery module in response to identifying that a situation in which the first and second conditions are satisfied is repeated a preset number of times or more.

7. The battery overcharging prevention device of any of the preceding claims, wherein:
the bypass circuit comprises a plurality of sub-bypass circuits (310); and
each of the sub-bypass circuits (310) comprises a bypass switch (311) and a bypass resistor (312) connected in series,
wherein:
the plurality of sub-bypass circuits (310) form bypass paths connectable to each of the first to Nth battery modules that are in parallel to bypass a charging current flowing into corresponding battery modules of the first to Nth battery modules; and
each bypass path of the bypass paths is configured as a path formed to connect a current input node to an uppermost battery cell of the corresponding battery modules, the bypass switch (311), the bypass resistor (312), and a discharging terminal.

8. The battery overcharging prevention device of claim 7, wherein the processor (200) is configured to close the bypass switch (311) of a sub-bypass circuit (310) of the sub-bypass circuits (310) connectable to the target battery module to bypass the charging current flowing into the target battery module through the bypass path.

9. The battery overcharging prevention device of any of the preceding claims, wherein:
the bypass circuit comprises sub-bypass circuits (310); and
each of the sub-bypass circuits (310) comprises a connection changeover switch (313), a bypass switch (311), and a bypass resistor (312) connected in series,
wherein the connection changeover switch (313), the bypass switch (311), and the bypass resistor (312) form a bypass path for bypassing a charging current flowing into each of a first battery module and a second battery module of the first to Nth battery modules that are adjacent to each other and connected in parallel.

10. The battery overcharging prevention device of claim 9, wherein:
the connection changeover switch (313) comprises first to third nodes and is configured to selectively connect the first and second nodes to the third node;
the first node is connectable to a current input node of an uppermost battery cell of the first battery module;
the second node is connectable to a current input node of the uppermost battery cell of the second battery module; and
the third node is connected to the bypass switch (311).

11. The battery overcharging prevention device of claim 9 or 10, wherein:
the bypass path connectable to the first battery module is configured as a path connecting the first node, the bypass switch (311), the bypass resistor (312), and a discharging terminal; and
the bypass path connectable to the second battery module is configured as a path connecting the second node, the bypass switch (311), the bypass resistor (312), and a discharging terminal.

12. The battery overcharging prevention device of any of claims 9 to 11, wherein the processor (200) is configured to connect the third node to the first node and to close the bypass switch (311) to bypass the charging current flowing into the first battery module through the bypass path in response to the first battery module being detected as the target battery module, and to the third node to the second node and to close the bypass switch (311) to bypass the charging current flowing into the second battery module through the bypass path in response to the second battery module being detected as the target battery module.

13. The battery overcharging prevention device of any of claims 10 to 12, wherein:
the bypass circuit comprises first to Kth sub-bypass circuits (310),K being a natural number corresponding to floor N/2, floor being a descending operator; and
an Lth sub-bypass circuit (310) of the first to Kth sub-bypass circuits (310) forms a shared bypass path for bypassing a charging current flowing into each of a 2L-1th battery module and a 2Lth battery module of the first to Nth battery modules, L being a natural number smaller than or equal to K.

14. A battery overcharging prevention method comprising:
detecting, by a processor (200), a target battery module in which an abnormal battery cell (10, 10a) is present based on a voltage change in each of battery cells (10, 10a) in first to Nth battery modules (N is a natural number greater than or equal to 2) that are connected in parallel, each battery module comprising a plurality of battery cells (10, 10a) connected in series; and
bypassing, by the processor (200), a current flowing into the target battery module to prevent overcharging of the target battery module caused by a charging current flowing into the target battery module from another battery module of the first to Nth battery modules connected in parallel to the target battery module.

15. A battery pack comprising:
first to Nth battery modules connected in parallel (N is a natural number greater than or equal to 2), wherein each battery module of the first to Nth battery modules comprises a plurality of battery cells (10, 10a) connected in series; and
a battery management system, BMS, configured to prevent overcharging caused by charging and discharging performed between the first to Nth battery modules,
wherein the BMS is configured to detect a target battery module of the first to Nth battery modules in which an abnormal battery cell is present based on a voltage change in each of the battery cells in the first to Nth battery modules, and to prevent overcharging of the target battery module by bypassing a current flowing into the target battery module.
